# EUROPEAN PATENT APPLICATION

(11) **EP 1 742 522 A2**
(43) Date of publication of application: **10.01.2007**
(21) Application number: 06014001.9
(22) Date of filing: 06.07.2006
(51) Int. Cl.: H05K 1/18, H05K 1/05

(54) **Light emitting diode module, backlight assembly and display device provided with the same**

(30) Priority: 08.07.2005 KR 20050061803
(71) Applicant: Samsung Electronics Co., Ltd., Yeongtong-gu Suwon-city, Gyeonggi-do 442-742 (KR)
(72) Inventor: Kim, Gi-Cherl, Guseong-eup Yongin-si Gyeonggi-do (KR); Lee, Sang-Yu 107-1601 Samgeomaeul Samsung Raemian, 629 Mabuk-ri Yongin-si Gyeonggi-do (KR); Yang, Byung-Choon, Bundang-gu Seongnam-si Gyeonggi-do (KR); Song, Chun-Ho, Seocho-gu Seoul (KR); Cho, Don-Chan 504-1206 Jeongdeunmaeul Sinhwa, Seongnam-si Gyeonggi-do (KR)
(74) Representative: Weitzel, Wolfgang

(57) **Abstract**

The present invention relates to a light emitting diode module, as well as a backlight assembly and a display device including the same. The light emitting diode module according to an exemplary embodiment of the present invention includes a printed circuit board having a plurality of junction holes, a plurality of light emitting diodes having a light emitting portion for emitting light and a lead portion with one end electrically connected to the light emitting portion and the other end positioned in a corresponding junction hole, and a junction member filled in the corresponding junction hole in which the lead portion is positioned.

## Description

This application claims priority to Korean Patent Application No. 10-2005-0061803, filed on July 08, 2005, and the contents of which in its entirety are herein incorporated by reference.

### BACKGROUND OF THE INVENTION

### (a) Field of the Invention

The present invention relates to a light emitting diode ("LED") module, and a backlight assembly and a display device having the same. More particularly, the present invention relates to an LED module having characteristics of improved heat radiating efficiency, as well as improved thermal resistance and durability, and a backlight assembly and a display device having the same.

### (b) Description of the Related Art

Among various display devices, a liquid crystal display ("LCD") has become one of the most represented display devices. This is due in part because of the much improved performance of the LCD due to rapidly developing semiconductor technologies along with the down-sizing, weight reduction and low power consumption of the LCD.

Since the LCD has various advantages such as the down-sizing, weight reduction and low power consumption, the LCD has gradually attracted attention as a display device alternative for a conventional cathode ray tube ("CRT"). Recently, an LCD has been used as a display device for almost all information processing devices that need a display device, such as small-sized products like cellular phones, personal digital assistances ("PDAs"), for example, and middle-/large-sized products such as monitors and televisions, for example.

A conventional LCD is a non-emissive type of display device that changes the alignment of liquid crystal molecules by applying a voltage to specifically align liquid crystal molecules for displaying images using optical characteristic changes, which are caused by the change of the alignment of liquid crystal molecules, such as birefringence, optical rotary power, dichroism and optical scattering characteristics.

Since the LCD uses a non-emissive type of display panel that does not emit light by itself, the liquid crystal display has a backlight assembly for supplying light to a rear surface of the display panel.

The backlight assembly has generally used a tube type of cold cathode fluorescent lamp ("CCFL"), an external electrode fluorescent lamp ("EEFL"), or the like as a light source. However, recently, a light emitting diode ("LED") having the merit of high luminance has frequently been used as the light source. A single light emitting diode can be used, or a module of a plurality of light emitting diodes may also be used.

However, when the light emitting diode is used as the light source, a substantial amount of heat is generated. The generated heat, in turn, may damage the light emitting diode or the display device,

### BRIEF SUMMARY OF THE INVENTION

The present invention has been made in an effort to provide a light emitting diode module having advantages of improved heat radiating efficiency, as well as improved heat resistance and durability.

In addition, the present invention has been made in an effort to provide a backlight assembly and a display device having the backlight assembly both having the light emitting diode module with the advantages of improved heat radiating efficiency, heat resistance and durability.

An exemplary embodiment of the present invention provides a light emitting diode module including a printed circuit board having a plurality of junction holes, a plurality of light emitting diodes having a light emitting portion for emitting light, and a lead portion with one end electrically connected to the light emitting portion, the other end positioned in the junction hole, and a junction member filled in the junction hole in which the lead portion is positioned.

The printed circuit board may be a metal core printed circuit board.

The printed circuit board may be made of a material including aluminum.

The printed circuit board may include a metal layer and a wiring layer, and the junction hole may be formed in the metal layer and the wiring layer.

The junction member may electrically connect the lead portion and the wiring layer.

A connecting pad may be formed within the junction hole, and the wiring layer may be connected to the connecting pad.

The wiring layer may be formed as a multi-layer.

The metal layer may also be formed as a multi-layer, and the wiring layer may include a wiring layer formed between the metal layers.

The wiring layer may include wiring layers formed on both facing surfaces of the metal layer.

The junction member may be made of a conductive material including tin.

A section of the junction hole may be formed as a shape formed by joining two inclined surfaces.

An exemplary embodiment of the present invention provides a backlight assembly including at least one light emitting diode module for emitting light, a supporting member for supporting the light emitting diode module, and a light diffusing member for diffusing light emitted by the light emitting diode module. The light emitting diode module includes a printed circuit board having a plurality of junction holes, and a plurality of light emitting diodes having a light emitting portion for emitting light, a lead portion with one end electrically connected to the light emitting portion and the other end positioned in the junction hole, and a junction member filled in the junction hole in which the lead portion is positioned.

The printed circuit board may be a metal core printed circuit board.

The printed circuit board may be made of a material including aluminum.

The printed circuit board may include a metal layer and a wiring layer, and the junction hole may be formed in the metal layer and the wiring layer.

The junction member may electrically connect the lead portion and the wiring layer.

A connecting pad may be formed within the junction hole, and the wiring layer may be connected to the connecting pad.

The wiring layer may be formed as a multi-layer.

The metal layer may also be formed as a multi-layer, and the wiring layer may include a wiring layer formed between metal layers.

The wiring layer may include wiring layers formed on both facing surfaces of the metal layer.

The junction member may be made of a conductive material including tin.

A section of the junction hole may be formed as a shape formed by joining two inclined surfaces.

An exemplary embodiment of the present invention provides a display device including a panel assembly for displaying images, a light emitting diode module for supplying light to the panel assembly, a light diffusing member disposed between the panel assembly and the light emitting diode module, and a supporting member for supporting the panel assembly, the light emitting diode module, and the light diffusing member. The light emitting diode module includes a printed circuit board having a plurality of junction holes, and a plurality of light emitting diodes having a light emitting portion for emitting light, a lead portion with one end electrically connected to the light emitting portion and the other end positioned in the junction hole, and a junction member filled in the junction hole in which the lead portion is positioned.

The printed circuit board may be a metal core printed circuit board,

The printed circuit board may be made of a material including aluminum.

The printed circuit board may include a metal layer and a wiring layer, and the junction hole may be formed in the metal layer and the wiring layer.

The junction member may electrically connect the lead portion and the wiring layer.

A connecting pad may be formed within the junction hole, and the wiring layer may be connected to the connecting pad.

The wiring layer may be formed as a multi-layer.

The metal layer may also be formed as a multi-layer, and the wiring layer may include a wiring layer formed between metal layers.

The wiring layer may include wiring layers formed on both facing surfaces of the metal layer.

The junction member may be made of a conductive material including tin.

A section of the junction hole may be formed as a shape formed by joining two inclined surfaces.

### BRIEF DESCRIPTION OF THE DRAWINGS

The above and other features and advantages of the present invention will become more apparent by describing in more detail exemplary embodiments thereof with reference to the attached drawings, in which:
FIG. 1 is a perspective view of a light emitting diode module according to an exemplary embodiment of the present invention;
FIG. 2 is a cross-sectional view taken along line II-II in the light emitting diode module of FIG. 1;
FIG. 3 is an exploded perspective view of a backlight assembly according to another exemplary embodiment of the present invention having the light emitting diode module of FIG. 1;
FIG. 4 is an exploded perspective view of a display device according to another exemplary embodiment of the present invention having the backlight assembly of FIG. 3;
FIG. 5 is a block diagram of a panel assembly of the display device of FIG. 4 and a circuit for driving the same;
FIG. 6 is an equivalent circuit schematic diagram of one pixel of the panel assembly of FIG. 5;
FIG. 7 is a partial cross-sectional view of a light emitting diode module included in a display device according to another exemplary embodiment of the present invention;
FIG. 8 is a partial cross-sectional view of a light emitting diode module included in a display device according to yet another exemplary embodiment of the present invention;
FIG. 9 is a partial cross-sectional view of a light emitting diode module included in a display device according to still another exemplary embodiment of the present invention; and
FIG. 10 is a partial cross-sectional view of a light emitting diode module included in a display device according to another exemplary embodiment of the present invention.

### DETAILED DESCRIPTION OF THE INVENTION

The present invention will now be described more fully hereinafter with reference to the accompanying drawings, in which exemplary embodiments of the present invention are shown. The present invention may, however, be embodied in many different forms and should not be construed as being limited to the exemplary embodiments set forth herein. Rather, these exemplary embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present there between. In contrast, when an element is referred to as being "directly on" another element, there are no intervening elements present. As used herein, the term. "and/or" includes any and all combinations of one or more of the associated listed items,

It will be understood that, although the terms first, second, third, etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments of the present invention are described herein with reference to cross section illustrations that are schematic illustrations of idealized embodiments of the present invention. As such, variations from the shapes of the illustrations as a result, for example, of manufacturing techniques and/or tolerances, are to be expected. Thus, exemplary embodiments of the present invention should not be construed as limited to the particular shapes of regions illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present invention.

Portions having no relation with the description will be omitted in order to explicitly explain the present invention. In addition, elements will be representatively explained in detail with respect to the first introduced exemplary embodiment using reference numerals, and in the remaining or subsequent exemplary embodiments, elements different from the first introduced exemplary embodiment will be explained.

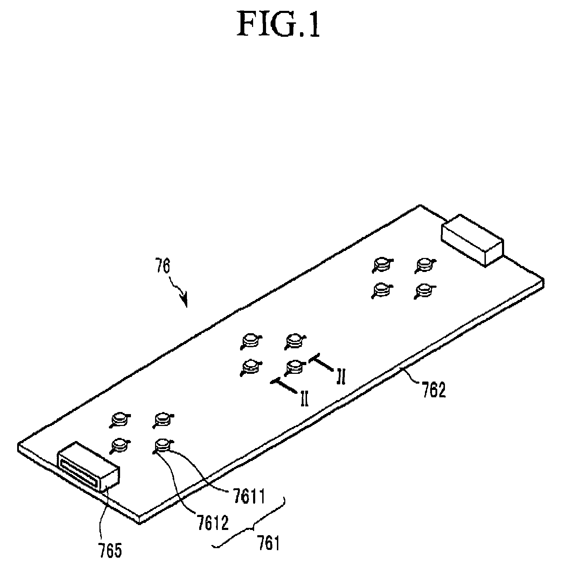

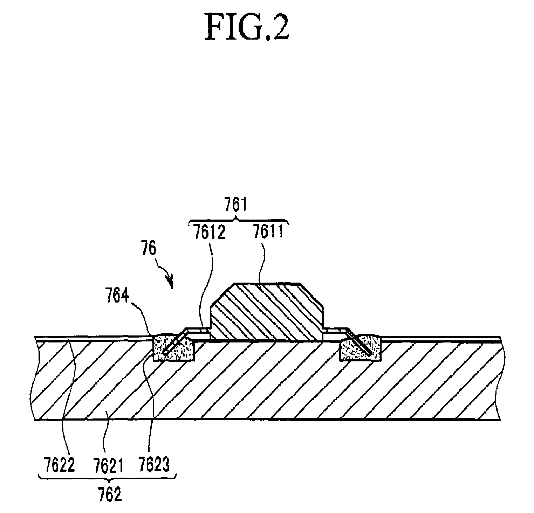

FIG. 1 illustrates a light emitting diode module 76 according to an exemplary embodiment of the present invention, and FIG. 2 is a cross-sectional view taken along line II-II in a light emitting diode module of FIG. 1.

As shown in FIG. 1, the light emitting diode module 76 includes a light emitting diode 761, a printed circuit board 762 on which the light emitting diode 761 is mounted, and a junction member 764 (shown in FIG. 2) for coupling the light emitting diode 761 and the printed circuit board 762 together. The light emitting diode module 76 may further include a connector 765 for electrically connecting the printed circuit board 762 to an external part. A wire or a cable is connected to the connector 765 so that the electrical power or a signal is applied to the printed circuit board 762 from the outside.

A plurality of light emitting diodes 761 are mounted on the printed circuit board 762, and the light emitting diodes 761 may be arranged in several groups. In FIG. 1, four light emitting diodes 761 having three primary colors of red, green and blue form one group. Since green light emitted from the light emitting diode 761 has a lower luminance than red light and blue light, two light emitting diodes 761, which emit green light, are disposed in each group in order to compensate for the lower luminance. However, it should be noted that colors of light emitted from the light emitting diode 761 are not inevitably limited to the three primary colors of red, green and blue colors, For example, a light emitting diode 761 emitting light of only a white color may be used, or a light emitting diode 761 emitting light of various other colors may also be used.

The light emitting diode module 76 will be explained with reference to FIG. 2 hereinafter.

The printed circuit board 762 shown in FIG. 2 is a metal core printed circuit board ("MCPCB") formed by adopting a metallic material as a substrate. The printed circuit board 762 is made of materials including aluminum (A1), for example. As such, by forming the printed circuit board 762 with a metallic material having good conductivity such as aluminum, heat generated in the light emitting diode 761 mounted on the printed circuit board 762 can be effectively radiated.

The printed circuit board 762 includes a metal layer 7621, a wiring layer 7622 formed on the metal layer 7621, and a junction hole 7623 formed in the metal layer 7621 and the wiring layer 7621. The junction hole 7623 may be formed in a shape of one of a circle, an ellipse and a polygon, for example, but is not limited thereto. In addition, although not shown in FIG. 2, the metal layer 7621 is covered with an insulating layer so as to be insulated from the wiring layer 7622. In this manner, the insulating layer (not shown) is intermediate the metal layer 7621 and the wiring layer 7622.

The light emitting diode 761 includes a light emitting portion 7611 for emitting light and a lead portion 7612 electrically connected to the light emitting portion 7611. One end of the lead portion 7612 is electrically connected to the light emitting portion 7611, and the other end of the lead portion 7612 is positioned within the junction hole 7623 of the printed circuit board 762. A rear surface of the light emitting portion 7611 of the light emitting diode 761 contacts the metal layer 7621 of the printed circuit board 762 formed of metallic material so that heat generated by the light emitting diode 761 can be effectively radiated through the printed circuit board 762. Although not shown in FIG. 2, in order to improve heat radiating efficiency, a heat radiating pad may be disposed between the metal layer 7621 and a rear surface of the light emitting portion 7611 to increase contact and decrease thermal resistance between the metal layer 7621 and the rear surface of the light emitting portion 7611. Tn addition, the light emitting diode 761 is not limited to the type of light emitting diode shown in FIG. 2, and a multi-light emitting diode having a plurality of lead portions and emitting light of a plurality of colors may alternatively be used.

A junction member 764 is filled in the junction hole 7623 of the printed circuit board 762 in which the lead portion 7612 of the light emitting diode 761 is disposed, so as to mount the light emitting diode 761 on the printed circuit board 762. That is, the junction member 764 electrically connects the lead portion 7612 of the light emitting diode 761 to the wiring layer 7622 of the printed circuit board 762. The junction member 764 may be formed of a conductive material including tin (Sn), and may also be formed without any lead (Pb), The junction member 764 formed in this manner has a merit of not being easily melted to flow even at a high temperature. The junction member 764 is typically referred to as solder. If the junction member 764 is changed to a liquid state by heat and is disposed at a connecting portion between the lead portion 7612 of the light emitting diode 761 and the wiring layer 7622 of the printed circuit board 762, the junction member 764 in a liquid state cools to solidify so that the junction member 764 firmly electrically connects the lead portion 7612 to the wiring layer 7622.

As such, by inserting the lead portion 7612 of the light emitting diode 761 within the junction hole 7623 formed in the printed circuit board 762 and filling the junction hole 7623 with the junction member 764, the light emitting diode 761 can be mounted on the printed circuit board 762 using a suitable quantity of the junction member 764, to ensure an even more stable connection between the printed circuit board 762 and the light emitting diode 761.

Since the junction member 764 is filled within a plurality of junction holes 7623 having a certain depth, problems such as a short circuit that may be caused by the flow of the junction member 764 while mounting the light emitting diode 761 on the printed circuit board 762 so as to contact the surrounding wiring is prevented.

In addition, melting of the junction member 764 and flowing toward the surrounding areas is prevented when heat generated while the light emitting diode module 76 operates. Furthermore, since the junction member 764 may stay within the junction hole 7623 even after being melted, a short circuit that may be caused by contact of the junction member 764 to neighboring wiring can also be prevented. Even after the junction member 764 is melted to a certain extent, the junction member 764 may electrically connect the lead portion 7612 of the light emitting diode 761 to the wiring layer 7622 of the printed circuit board 762. Accordingly, stability of the light emitting diode module 76 can be substantially enhanced.

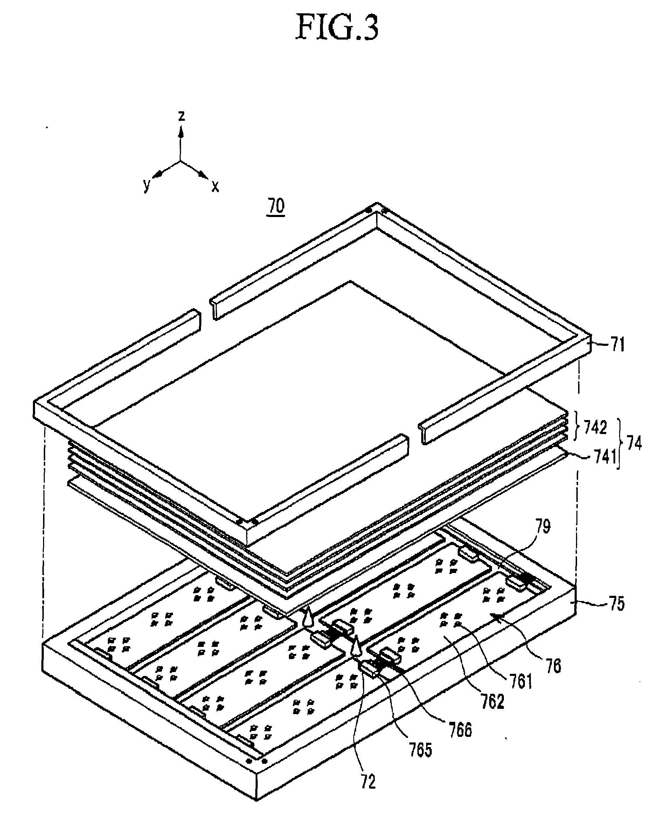

FIG. 3 shows a backlight assembly 70 having the light emitting diode module 76 of FIG.1. The number of light emitting diode modules 76 included in the backlight assembly 70 may vary depending on the type and size of the backlight assembly 70.

As shown in FIG. 3, the backlight assembly 70 according to a first exemplary embodiment of the present invention includes a divided-type first supporting member 71 having a "⊏" shape (e.g., an open rectangle), a second supporting member 75, a light emitting diode module 76 disposed between the first and second supporting members 71 and 75, a light diffusing member 74 and a reflection sheet 79. In addition, the backlight assembly 70 may further include a supporting column 72 for supporting the light diffusing member 74 to be separated from the light emitting diode module 76.

Although FIG. 3 shows that both the first and second supporting members 71 and 75 are used, this is but an example of an exemplary embodiment of the present invention and is not limited thereto. Thus, it may be sufficient that only one of the first and second supporting members 71 and 75 is used.

The light diffusing member 74 includes a diffuser 741 for diffusing light emitted from the light diode module 76 and an optical sheet 742 for enhancing luminance characteristics of light having passed through the diffuser 741.

The optical sheet 742 includes a diffuser sheet for further diffusing light having passed through the diffuser 741 such that the light does not partially concentrate to thereby improve light uniformity, and a prism sheet for causing light having passed through the diffuser sheet to vertically advance so as to improve luminance. In addition, the optical sheet 742 may further include a protecting sheet for protecting the diffuser sheet and the prism sheet that may be easily scratched and for protecting against external impacts and inflow of foreign particles.

The reflection sheet 79 is disposed between the second supporting member 75 and the light emitting diode module 76, and reflects light emitted from the light emitting diode module 76 toward the front direction to thereby decrease loss of light and help the diffusion of light so as to improve uniformity thereof.

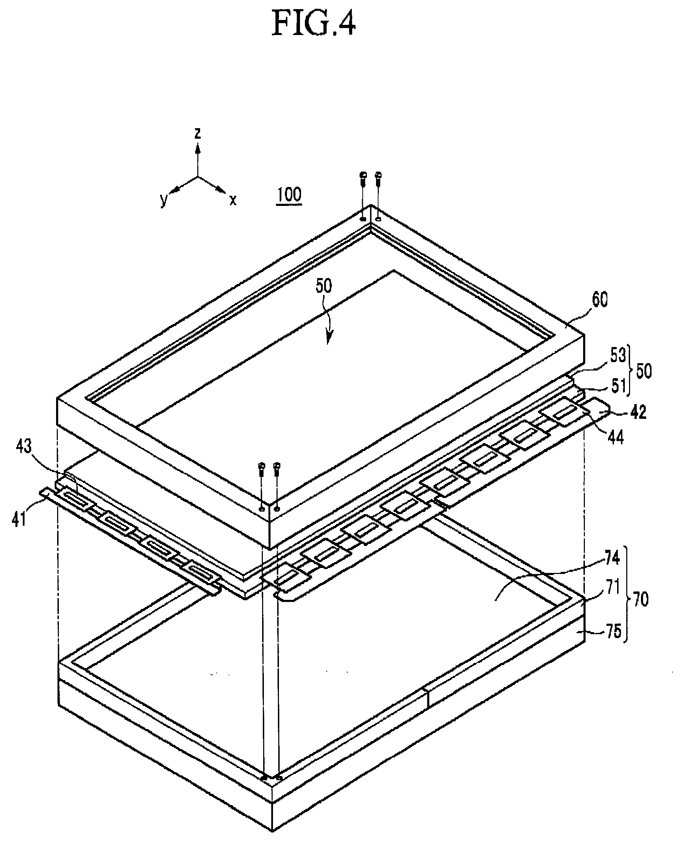

FIG. 4 shows a display device 100 having the backlight assembly 70 of FIG. 3.

Although FIG. 4 shows a liquid crystal panel as an exemplary embodiment of a panel assembly 50 used in the display device 100, this is an example of an exemplary embodiment of the present invention and is not limited thereto. Different kinds of non-emissive type display panels may be used,

As shown in FIG. 4, the display device 100 according to this exemplary embodiment of the present invention includes the backlight assembly 70 for supplying light and the panel assembly 50 for receiving light and displaying images. Further, the display device 100 includes a third supporting member 60 for fixing the panel assembly 50 on the backlight assembly 70,

The display device 100 further includes driving PCBs 41 and 42 for supplying driving signals to the panel assembly 50 and driving integrated circuit ("IC") packages 43 and 44 for electrically connecting the driving PCBs 41 and 42 and the panel assembly 50, The driving IC packages 43 and 44 may be formed as a chip on film ("COF") or a tape carrier package ("TCP"),

The driving PCB includes a gate driving PCB 41 and a data driving PCB 42. The driving IC package includes a gate driving IC package 43 for connecting the panel assembly 50 and the gate driving PCB 41 and a data driving IC package 44 for connecting the panel assembly 50 and the data driving PCB 42.

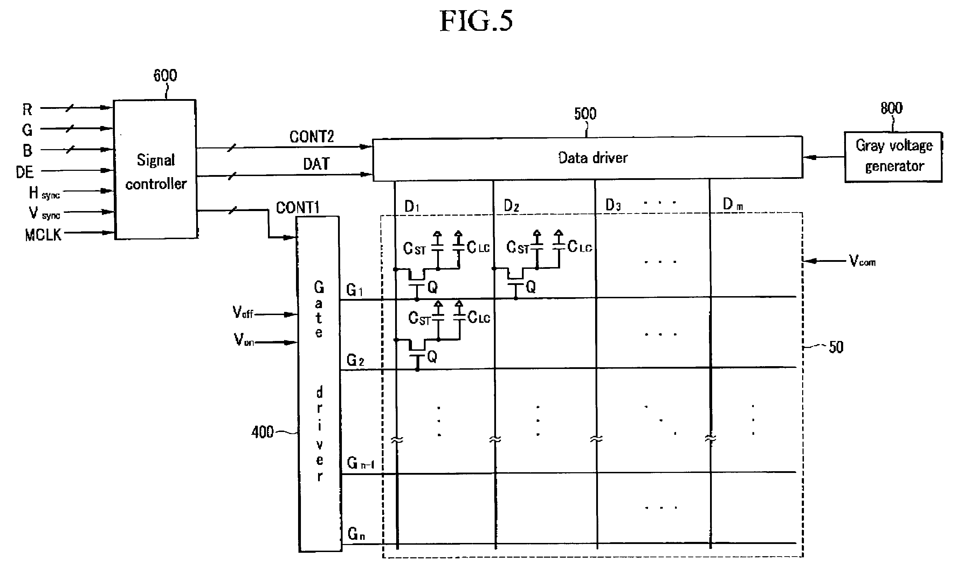

The panel assembly 50 includes a first display panel 51 and a second display panel 53 arranged to face the first display panel 51 while a liquid crystal layer 52 (not shown) is interposed between the panels 51 and 53. Here, the first display panel 51 is a rear substrate, and the second display panel 53 is a front substrate. The driving IC packages 43 and 44 are connected to the first display panel 51. The gate driving IC package 43 is attached to one edge of the first display panel, and the gate driving IC package 43 includes an IC chip constituting a gate driver 400 (shown in FIG. 5). The data driving IC package 44 is attached to the other edge of the first display panel 51, The data driving IC package 44 includes an IC chip constituting a data driver 500 and a gray voltage generator 800 (shown in FIG. 5).

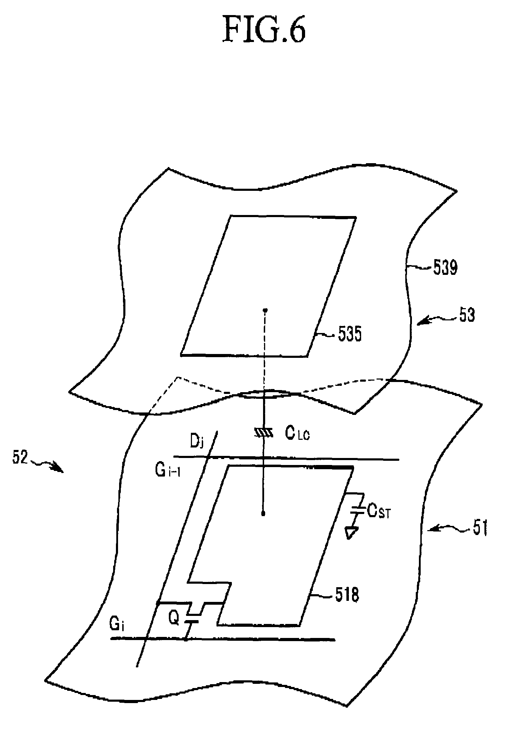

Referring to FIG. 5 and to FIG. 6, the panel assembly 50 and an apparatus for driving the same will be explained.

As shown in FIG. 5 and FIG. 6, the first display panel 51 includes a plurality of signal lines G₁ to Gₙ and D₁ to Dₘ. The first and second display panels 51 and 53 are connected to the signal lines G₁ to Gₙ and D₁ to Dₘ (shown as signal lines Gᵢ and Dⱼ, respectively, in FIG. 6), and include a plurality of pixels substantially arranged in a matrix.

The signal lines G₁ to Gₙ and D₁ to Dₘ include a plurality of gate lines G₁ to Gₙ for transmitting gate signals (also referred to as scanning signals) and data lines D₁ to Dₘ for transmitting data signals. The gate lines G₁ to Gₙ substantially extend in a row direction parallel to one another, and the data lines D₁ to Dₘ substantially extend in a column direction parallel to one another.

Each pixel includes a switching element Q connected to the signal lines G₁ to Gₙ and D₁ to Dₘ, and a liquid crystal capacitor C_{LC} and a storage capacitor C_{ST} each connected to the switching element Q. If necessary, the storage capacitor C_{ST} can be omitted.

A thin film transistor may be an example of the switching element Q, and this is formed on the first display panel 51. The thin film transistor is a three terminal element. A control terminal and an input terminal of the thin film transistor are connected to the gate lines G₁ to Gₙ and the data lines D₁ to Dₘ, respectively, while an output terminal thereof is connected to the liquid crystal capacitor C_{LC} and the storage capacitor C_{ST}.

The signal controller 600 controls operations of the gate driver 400 and the data driver 500. The gate driver 400 applies gate signals constituted by a combination of a gate-on voltage Von and a gate-off voltage Voff to the gate lines G₁ to Gₙ, and the data driver 500 applies data voltages to the data lines D₁ to Dₘ. The gray voltage generator 800 generates two sets of gray voltages related to transmittance of the pixel, and supplies the generated gray voltages to the data driver 500 as data voltages. One of the two sets of gray voltages has a positive value with respect to the common voltage Vcom, and the other of the two sets of gray voltages has a negative value with respect to the common voltage Vcom.

As shown in FIG. 6, the liquid crystal capacitor C_{LC} has two terminals including a pixel electrode 518 of the first display panel 51 and a common electrode 539 of the second display panel 53, The liquid crystal layer 52 disposed between the two electrodes 518 and 539 serves as a dielectric material. The pixel electrode 518 is connected to the switching element Q. The common electrode 539 is formed on the entire surface of the second display panel 53, and a common voltage Vcom is applied to the common electrode 539. Unlike FIG. 6, the common electrode 539 may be provided on the first display panel 51. In this case, at least one of the two electrodes 518 and 539 can be formed in a linear or bar shape. A color filter 535, which endows color to transmitted light, is formed on the second display panel 53. Unlike FIG. 6, the color filter 535 may be formed on the first display panel 51.

The storage capacitor C_{ST}, which assists the liquid crystal capacitor C_{LC}, has a separate signal line (not shown) provided on the first display panel 51 and the pixel electrode 518 to overlap each other with an insulator therebetween. A fixed voltage such as the common voltage Vcom is applied to the separate signal line. However, the storage capacitor C_{ST} may be formed by the pixel electrode 518 and the overlying previous gate lines G₁ to Gₙ arranged to overlap each other having an insulator therebetween.

A polarizer (not shown), which polarizes light, is attached to an outer surface of at least one of the two substrates 51 and 53 of the panel assembly 50.

Under such structures, if the thin film transistor, which is a switching element, is turned on, an electric field is generated between the pixel electrode 518 and the common electrode 539. The alignment angle of liquid crystal of the liquid crystal layer 52 between the first display panel 51 and the second display panel 53 varies depending on the electric field, and a change in the alignment angle of the liquid crystal causes a change in transmittance of light so that desired images are realized.

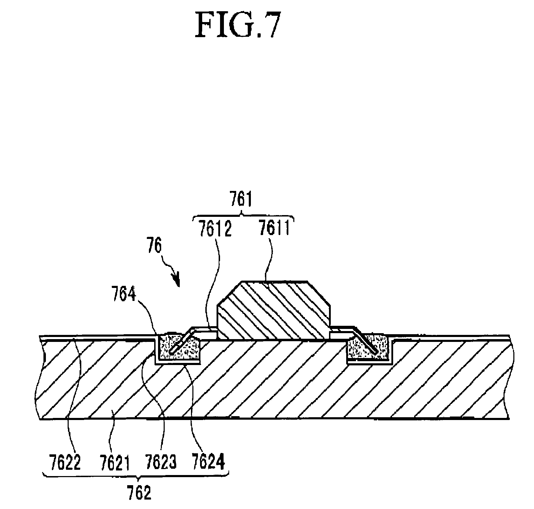

Referring to FIG. 7, another exemplary embodiment of the present invention will be explained. FIG. 7 is a cross-sectional view illustrating a light emitting diode module 76 included in a display device according to the another exemplary embodiment of the present invention.

As shown in FIG. 7, the light emitting diode module 76 further includes a connecting pad 7624 formed within a junction hole 7623 of the printed circuit board 762 and connected to a wiring layer 7622, Thus, the junction member 764 may connect the lead portion 7612 of the light emitting diode 761 and the wiring layer 7622 of the printed circuit board 762 together in a more stable connection than if the connecting pad 7624 were absent.

That is, a surface area of a connecting region with the junction member 764 becomes larger because of the connecting pad 7624 connected to the wiring layer 7622 of the printed circuit board 762, and this may effectively prevent the junction member 764 from being melted by heat flow and fail to contact the wiring layer 7622.

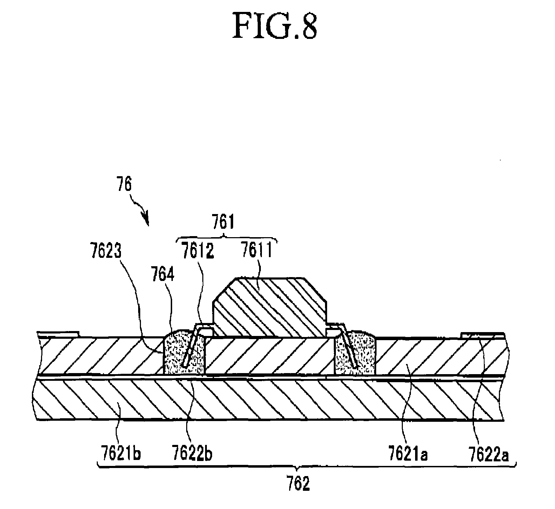

Referring to FIG. 8, a third exemplary embodiment of the present invention will be explained. FIG. 8 is a cross-sectional view illustrating a light emitting diode module 76 included in a display device according to yet another exemplary embodiment of the present invention.

As shown in FIG. 8, the printed circuit board 762 includes wiring layers 7622a and 7622b and metal layers 7621a and 7621b that are formed as a multi-layer. At least one of the wiring layers 7622a and 7622b is formed between the metal layers 7621a and 7621b. The junction hole 7623 exposes a portion of the wiring layer 7622b formed between the metal layers 7621a and 7621b. The junction member 764 electrically connects the lead portion 7612 of the light emitting diode 761 to the wiring layer 7622b formed between the metal layers 7621a and 7621b.

As such, if the printed circuit board 762 formed with a multi-layer is used, the light emitting diodes 761 can be more intensively mounted on the printed circuit board 762, and the printed circuit board 762 and the light emitting diodes 761 can be connected to each other in a more stable fashion. That is, the junction hole 7623 is relatively deep so that the lead portion 7612 disposed within the junction hole 7623 can be longer, Accordingly, a sufficient amount of the junction member 764 can be used so that the light emitting diode 761 can be firmly mounted on the printed circuit board 762.

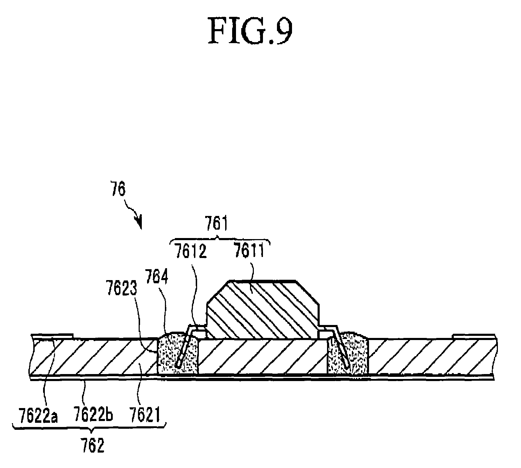

Referring to FIG. 9, still another exemplary embodiment of the present invention will be explained. FIG. 9 is a cross-sectional view illustrating a light emitting diode module 76 included in a display device according to the still another exemplary embodiment of the present invention.

As shown in FIG. 9, in the printed circuit board 762, the wiring layers 7622a and 7622b are formed on both sides of the metal layer 7621, and the junction hole 7623 is formed to penetrate the metal layer 7621. The junction member 764 electrically connects the wiring layer 7622b, which is formed on the surface opposite to the surface on which the light emitting diode 761 is mounted, and the lead portion 7612 of the light emitting diode 761, through the junction hole 7623.

Since the junction hole 7623 can be formed more deeply, the lead portion 7612 positioned in the junction hole 7623 can be longer. Thus, the light emitting diode 761 can be more firmly mounted on the printed circuit board 762 using a sufficient amount of the junction member 764 in the junction hole 7623. In addition, the junction member 764 can be prevented from flowing to unnecessarily contact the neighboring wiring. Furthermore, the wiring layer 7622 of the printed circuit board 762 and the lead portion 7612 of the light emitting diode 761 can be connected to one another in a more stable manner. Moreover, the light emitting diodes 761 can be intensively mounted, and the printed circuit board 762 can be simply and cost-effectively formed.

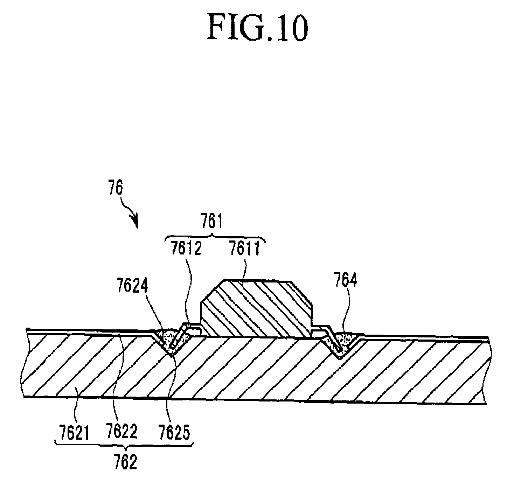

Referring to FIG. 10, another exemplary embodiment of the present invention will be explained. FIG. 10 is a cross-sectional view illustrating a light emitting diode module 76 included in a display device according to the another exemplary embodiment of the present invention.

As shown in FIG. 10, the section of the junction hole 7625 formed in the printed circuit board 762 has a shape formed by joining two inclined surfaces. That is, the section of the junction hole 7625 is substantially formed with a shape of a "V". As such, by forming the junction hole 7625, it becomes easy to process the printed circuit board 762 to form the junction hole 7625, and it also becomes easy to form the connecting pad 7624 connected to the wiring layer 7622.

As described above, according to exemplary embodiments of the present invention, a light emitting diode module having improved heat radiating efficiency as well as improved thermal resistance and durability can be provided.

Since a metal core printed circuit board formed of a metallic material having high conductivity such as aluminum is used as the printed circuit board of the light emitting diode module, heat generated by the light emitting diode can be effectively radiated.

In addition, since the junction member mounting the light emitting diode on the printed circuit board is formed of a conductive material including tin (Sn), the junction member may hold at a relatively high temperature, In particular, if the junction member does not include lead (Pb), the thermal resistance of the junction member is further improved.

In addition, since the lead portion of the light emitting diode is coupled to the junction member within the junction hole formed in the printed circuit board, the light emitting diode and the printed circuit board can be firmly coupled using a sufficient amount of the junction member. The heated junction member can be prevented from flowing to unnecessarily contact neighboring wiring and thereby cause a short circuit. Since the junction member may still be positioned within the junction hole even after the junction member is melted to some degree, the electrical connection between the light emitting diode and the printed circuit board can be maintained.

In addition, the backlight assembly and the display device having the backlight assembly, both having the above-mentioned light emitting diode, can be provided.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A light emitting diode module comprising;
a printed circuit board having a plurality of junction holes;
a plurality of light emitting diodes having a light emitting portion for emitting light and a lead portion with one end electrically connected to the light emitting portion and the other end positioned in a corresponding junction hole; and
a junction member filled in the corresponding junction hole in which the lead portion is positioned.

2. The light emitting diode module of claim 1, wherein the printed circuit board is a metal core printed circuit board.

3. The light emitting diode module of claim 2, wherein the printed circuit board is made of aluminum.

4. The light emitting diode module of claim 2, wherein;
the printed circuit board comprises a metal layer and a wiring layer; and
the junction hole is formed in the metal layer and the wiring layer.

5. The light emitting diode module of claim 4, wherein the junction member electrically connects the lead portion and the wiring layer.

6. The light emitting diode module of claim 4, wherein:
a connecting pad is formed within the junction hole; and
the wiring layer is connected to the connecting pad.

7. The light emitting diode module of claim 4, wherein the wiring layer is formed as a multi-layer.

8. The light emitting diode module of claim 7, wherein:
the metal layer is formed as a multi-layer; and
the multi-layer wiring layer comprises a wiring layer formed between the metal layers.

9. The light emitting diode module of claim 7, wherein the wiring layer comprises wiring layers formed on both facing surfaces of the metal layer.

10. The light emitting diode module of claim 1, wherein the junction member is made of a conductive material including tin (Sn).

11. The light emitting diode module of claim 10, wherein the conductive material is absent any lead (Pb).

12. The light emitting diode module of claim 1, wherein a section of the junction hole is formed in a shape by joining two inclined surfaces.

13. A backlight assembly comprising:
at least one light emitting diode module for emitting light;
a supporting member for supporting the light emitting diode module; and
a light diffusing member for diffusing light emitted by the light emitting diode module,
wherein the light emitting diode module comprises
a printed circuit board having a plurality of junction holes,
a plurality of light emitting diodes having a light emitting portion for emitting light and a lead portion with one end electrically connected to the light emitting portion and the other end positioned in a corresponding junction hole, and
a junction member filled in the corresponding junction hole in which the lead portion is positioned,

14. The backlight assembly of claim 13, wherein the printed circuit board is a metal core printed circuit board,

15. The backlight assembly of claim 14, wherein the printed circuit board is made of aluminum.

16. The backlight assembly of claim 14, wherein:
the printed circuit board comprises a metal layer and a wiring layer; and
each junction hole is formed in the metal layer and the wiring layer.

17. The backlight assembly of claim 16, wherein the junction member electrically connects the lead portion and the wiring layer.

18. The backlight assembly of claim 16, wherein:
a connecting pad is formed within the junction hole; and
the wiring layer is connected to the connecting pad.

19. The backlight assembly of claim 16, wherein the wiring layer is formed as a multi-layer.

20. The backlight assembly of claim 19, wherein:
the metal layer is formed as a multi-layer; and
the multi-layer wiring layer comprises a wiring layer formed between the metal layers.

21. The backlight assembly of claim 19, wherein the multi-layer wiring layer comprises wiring layers formed on both facing surfaces of the metal layer.

22. The backlight assembly of claim 13, wherein the junction member is made of a conductive material including tin.

23. The backlight assembly of claim 22, wherein the conductive material is absent any lead (Pb).

24. The backlight assembly of claim 13, wherein a section of the junction hole is formed in a shape by joining two inclined surfaces extending from a major surface plane defining the printed circuit board.

25. A display panel comprising:
a panel assembly for displaying images;
a light emitting diode module for supplying light to the panel assembly;
a light diffusing member disposed between the panel assembly and the light emitting diode module; and
a supporting member for supporting the panel assembly, the light emitting diode module and the light diffusing member,
wherein the light emitting diode module comprises
a printed circuit board having a plurality of junction holes,
a plurality of light emitting diodes having a light emitting portion for emitting light and a lead portion with one end electrically connected to the light emitting portion and the other end positioned in a corresponding junction hole, and
a junction member filled in the corresponding junction hole in which the lead portion is positioned.

26. The display panel of claim 25, wherein the printed circuit board is a metal core printed circuit board.

27. The display panel of claim 26, wherein the printed circuit board is made of aluminum,

28. The display panel of claim 26, wherein:
the printed circuit board comprises a metal layer and a wiring layer; and
each junction hole is formed in the metal layer and the wiring layer,

29. The display panel of claim 28, wherein the junction member electrically connects the lead portion and the wiring layer.

30. The display panel of claim 28, wherein:
a connecting pad is formed within the junction hole; and
the wiring layer is connected to the connecting pad.

31. The display panel of claim 28, wherein the wiring layer is formed as a multi-layer.

32. The display panel of claim 31, wherein:
the metal layer is formed as a multi-layer; and
the multi-layer wiring layer comprises a wiring layer formed between the metal layers,

33. The display panel of claim 31, wherein the multi-layer wiring layer comprises wiring layers formed on both facing surfaces of the metal layer.

34. The display panel of claim 25, wherein the junction member is made of a conductive material including tin.

35. The display panel of claim 25, wherein a section of the junction hole is formed in a shape by joining two inclined surfaces extending from a major surface plane defining the printed circuit board.
